# EUROPÄISCHE PATENTSCHRIFT

(11) **EP 3 329 741 B1**
(45) Veröffentlichungstag und Bekanntmachung des Hinweises auf die Patenterteilung: **04.10.2023**
(21) Anmeldenummer: 16751526.1
(22) Anmeldetag: 28.07.2016
(51) Int. Cl.: H05B 45/50, H05B 45/00, H05B 45/18

(54) **OPTOELEKTRONISCHE BAUGRUPPE UND VERFAHREN ZUM BETREIBEN EINER OPTOELEKTRONISCHEN BAUGRUPPE**
OPTOELECTRONIC ASSEMBLY AND METHOD FOR OPERATING AN OPTOELECTRONIC ASSEMBLY
BLOC OPTOELECTRONIQUE ET PROCÉDÉ DE FONCTIONNEMENT D'UN BLOC OPTOÉLECTRONIQUE

(30) Priorität: 31.07.2015 DE 102015112635
(43) Veröffentlichungstag der Anmeldung: 06.06.2018
(73) Patentinhaber: Pictiva Displays International Limited, Dublin A96 VR66 (IE)
(72) Erfinder: REGAU, Kilian, 93047 Regensburg (DE); FARRNBACHER, Jörg, 93049 Regensburg (DE); HOEFLINGER, Benjamin, 93059 Regensdorf (DE); VEHOFF, Thorsten, 93047 Regensburg (DE); POHL-ZANDER, Tobias, 93049 Regensburg (DE)
(74) Vertreter: Epping - Hermann - Fischer
(86) Internationale Anmeldenummer: PCT/EP2016/068041
(87) Internationale Veröffentlichungsnummer: WO 2017/021276

(56) Entgegenhaltungen:
- WO-A1-2014/037908
- US-A1- 2012 249 516
- US-B1- 6 313 589
- US-B2- 7 576 493

## Beschreibung

Die Erfindung betrifft eine optoelektronische Baugruppe und ein Verfahren zum Betreiben einer optoelektronischen Baugruppe.

Eine herkömmliche optoelektronische Baugruppe weist ein organisches lichtemittierendes Bauelement, beispielsweise eine OLED, ein Steuergerät und ein, zwei oder mehr Messvorrichtungen zum Erfassen entsprechender Messwerte auf. Das Steuergerät steuert und/oder regelt das organische lichtemittierende Bauelement abhängig von den Messwerten. Das Steuergerät kann als Treiber bezeichnet werden. Das organische lichtemittierende Bauelement befindet sich im normalen Betrieb im Leuchtbetrieb, in dem Licht erzeugt wird.

Bei organischen lichtemittierenden Bauelementen weist die Vorwärtsspannung im normalen Betrieb häufig eine starke Temperaturabhängigkeit auf. Insbesondere kann bei niedrigen Temperaturen die Vorwärtsspannung relativ hoch sein und bei hohen Temperaturen kann die Vorwärtsspannung relativ gering sein. Die starke Temperaturabhängigkeit der Vorwärtsspannung einer OLED kann ein Problem darstellen.

Zum Lösen dieses Problems kann man beispielsweise das Steuergerät so einrichten, dass es eine Ausgangsspannung bereitstellen kann, die einem sehr großen Bereich variierbar ist. In anderen Worten können die starken Spannungsschwanken akzeptiert werden und das Steuergerät, beispielsweise ein Treiber, kann auf die hohe benötigte Spannung ausgelegt werden. Insbesondere kann das Steuergerät für den Betrieb des organischen lichtemittierenden Bauelements bei kalten Temperaturen leistungstechnisch sehr stark ausgelegt werden, da die von dem organischen lichtemittierenden Bauelement benötigte Vorwärtsspannung bei den tiefen Temperaturen stark ansteigt. Dies kann zum einen zu hohen Kosten führen und ist zum anderen nicht immer möglich, insbesondere bei Anwendungen, bei denen die Ausgangsspannung des Steuergeräts technisch und/oder normativ begrenzt ist. Als Beispiel sei hierzu die Verwendung der optoelektronischen Baugruppe in einem Kraftfahrzeug, insbesondere einem Auto, genannt, bei der als technische Begrenzung die zur Verfügung stehende Batteriespannung des entsprechenden Kraftfahrzeugs abzüglich Spannungseinbrüchen besteht. Falls die Spannung hochgesetzt werden muss, entsteht ein technischer und/oder kostentechnischer Mehraufwand. Auch in der Allgemeinbeleuchtung kann eine normative Begrenzung vorliegen. Je nach Anwendung entsteht dadurch ein deutlich höherer Isolationsmehraufwand, insbesondere wenn die Spannung nicht auf beispielsweise 34V Gleichspannung oder 60V Gleichspannung begrenzt wird. Muss man diese Grenzen nur wegen der kalten Temperaturen überschreiten, bedeutet das einen deutlichen Kostenmehraufwand. Aufgrund des Tieftemperaturverhaltens von OLEDs muss daher auf andere, besonders teure und/oder ineffizientere Schaltungstopologien umgestiegen werden.

US 6 313 589 B1 zeigt eine optoelektronische Baugruppe, mit einem organischen lichtemittierenden Bauelement, einem Temperatursensor zum Erfassen eines Temperaturwerts, einem Steuergerät, das mit dem organischen lichtemittierenden Bauelement und dem Temperatursensor gekoppelt ist und das dazu eingerichtet ist, bei einem Einschalten des organischen lichtemittierenden Bauelements an das organische lichtemittierende Bauelement eine Gleichspannung anzulegen, die größer als die aktuelle Schwellenspannung des organischen lichtemittierenden Bauelements ist, falls ein Messwert gleich wie oder größer als ein vorgegebener Schwellenwert ist.

Die Druckschrift US 2012/249516 A1 beschreibt eine Amoled-Mikroanzeigevorrichtung mit aktiver Temperaturregelung.

Die Druckschrift US 7 576 493 B2 beschreibt ein Steuergerät für LED-Lampen in Fahrzeugen, die in Umgebungen mit niedrigen Temperaturen eingesetzt werden.

Die Druckschrift WO 2014/037908 A1 beschreibt eine Beleuchtungsvorrichtung mit integriertem Linsenkühlkörper.

Eine Aufgabe der Erfindung ist es, eine optoelektronische Baugruppe bereitzustellen, die in einem breiten Temperaturbereich, insbesondere bei niedrigen Temperaturen, mit einer geringen Leistung, insbesondere mit einer geringen Vorwärtsspannung, betreibbar und/oder einfach und kostengünstig herstellbar ist.

Eine Aufgabe der Erfindung ist es, ein Verfahren zum Betreiben einer optoelektronischen Baugruppe bereitzustellen, das in einem breiten Temperaturbereich, insbesondere bei niedrigen Temperaturen, mit einer geringen Leistung, insbesondere mit einer geringen Vorwärtsspannung, und/oder einfach und kostengünstig durchführbar ist.

Die Aufgaben werden gelöst durch eine optoelektronische Baugruppe gemäß den unabhängigen Ansprüchen 1 und 3 sowie durch ein Verfahren gemäß den unabhängigen Ansprüchen 4 und 6.

Eine Aufgabe wird gemäß einem Aspekt der Erfindung gelöst durch eine optoelektronische Baugruppe mit einem organischen lichtemittierenden Bauelement, einem Temperatursensor zum Erfassen eines Temperaturwerts, und einem Steuergerät, das mit dem organischen lichtemittierenden Bauelement und dem Temperatursensor gekoppelt ist. Das Steuergerät ist dazu eingerichtet, bei einem Einschalten des organischen lichtemittierenden Bauelements an das organische lichtemittierende Bauelement eine Wechselspannung anzulegen, die zumindest zeitweise kleiner als eine aktuelle Schwellenspannung des organischen lichtemittierenden Bauelements ist, falls der erfasste Temperaturwert kleiner als ein vorgegebener Temperaturschwellenwert ist, und an das organische lichtemittierende Bauelement eine Gleichspannung anzulegen, die größer als die aktuelle Schwellenspannung des organischen lichtemittierenden Bauelements ist, falls ein Messwert gleich wie oder größer als ein vorgegebener Schwellenwert ist.

Im normalen Betrieb wird das organische lichtemittierende Bauelement mit der Gleichspannung betrieben und somit mit Gleichstrom versorgt. Mithilfe der Wechselspannung kann vor dem normalen Betrieb elektrische Leistung in das organische lichtemittierende Bauelement eingebracht werden und so das organische lichtemittierende Bauelement vor dem normalen Betrieb erwärmt werden. In anderen Worten kann mittels der Wechselspannung nach dem Anschalten und vor dem normalen Betrieb des organischen lichtemittierenden Bauelements eine Wärmeenergie in das organische lichtemittierende Bauelement eingeprägt bzw. eingebracht werden. Das erwärmte organische lichtemittierende Bauelement kann dann im normalen Betrieb mit einer geringen Vorwärtsspannung und/oder Leistung betrieben werden.

Mittels des Wechselstroms kann bei gleicher Leistungsfähigkeit des Steuergeräts eine höhere Wärmeenergie eingebracht werden und die Wärmeenergie kann schneller eingebracht werden, als mittels des Gleichstroms während des normalen Betriebs des organischen lichtemittierenden Bauelements. Für das Anlegen der Wechselspannung sind keine zusätzlichen Anschlüsse an dem organischen lichtemittierenden Bauelement nötig. Für das Erwärmen des organischen lichtemittierenden Bauelements sind keine zusätzlichen Heizungselemente nötig. Es ist somit mittels eines einfachen und/oder kostengünstigen Steuergeräts ein schnelles Erwärmen des organischen lichtemittierenden Bauelements und damit ein kostengünstiges und/oder einfaches Betreiben der optoelektronischen Baugruppe möglich.

Dass die Wechselspannung zumindest zeitweise kleiner als die aktuelle Schwellenspannung des organischen lichtemittierenden Bauelements ist, kann beispielsweise bedeuten, dass die Wechselspannung um einen Spannungswert unterhalb der aktuellen Schwellenspannung schwingt und lediglich in kurzen Zeitintervallen um die Schwingungsmaxima oberhalb der aktuellen Schwellenspannung liegt. Dass die Schwellenspannung aktuell ist, bedeutet, dass die Schwellenspannung von der Temperatur abhängig ist und kein fest vorgegebener Wert ist, und dass das Steuergerät für die Steuerung die zu dem aktuellen Zeitpunkt entsprechende Schwellenspannung als Referenz verwendet. Die aktuelle Schwellenspannung kann beispielsweise während des Betriebs der optoelektronischen Baugruppe erfasst werden oder sie kann werkseitig in Abhängigkeit von der Temperatur ermittelt und auf einem Speichermedium der optoelektronischen Baugruppe abgespeichert werden, so dass das Steuergerät abhängig von der erfassten Temperatur die aktuelle Schwellenspannung von dem Speichermedium lesen kann. Der vorgegebene Temperaturschwellenwert kann beispielsweise werkseitig empirisch ermittelt und auf einem Speichermedium der optoelektronischen Baugruppe gespeichert werden.

Bei einer Weiterbildung ist das Steuergerät so eingerichtet, dass die Wechselspannung immer kleiner als die aktuelle Schwellenspannung des organischen lichtemittierenden Bauelements ist. Dies bewirkt, dass das organische lichtemittierende Bauelement während des Aufheizens nicht leuchtet und der Aufheizvorgang somit von außen nicht wahrnehmbar ist. Des Weiteren fließt während des Aufheizens kein Strom über die organischen Schichten des organischen lichtemittierenden Bauelements, weshalb diese während des Aufheizens keinem wesentlichen Verschleiß unterliegen, wodurch die Lebensdauer des organischen lichtemittierenden Bauelements durch den Aufheizvorgang nicht beeinflusst wird.

Der Messwert ist ein weiterer Temperaturwert und der Schwellenwert ist der Temperaturschwellenwert. In anderen Worten kann während des Aufheizens einmal, zweimal oder mehrere Male die aktuelle Temperatur des organischen lichtemittierenden Bauelements erfasst werden und abhängig von der aktuellen Temperatur kann dann der Aufheizvorgang beendet und/oder der normale Betrieb aufgenommen werden. Alternativ dazu kann der Messwert ein Stromwert eines Vorwärtsstroms sein, der über das organische lichtemittierende Bauelement fließt, oder ein Zeitwert einer Zeitdauer, die seit Beginn des Aufheizvorgang vergangen ist. Dies kann auf einfache Weise dazu beitragen, zu erkennen, wann der Aufheizvorgang beendet werden kann und der normale Betrieb, insbesondere der Leuchtbetrieb, des organischen lichtemittierenden Bauelements aufgenommen werden kann.

Eine Aufgabe wird gemäß einem Aspekt der Erfindung gelöst durch eine optoelektronische Baugruppe, mit einem organischen lichtemittierenden Bauelement, einem Sensor zum Erfassen eines Messwertes, und einem Steuergerät, das mit dem organischen lichtemittierenden Bauelement gekoppelt ist. Das Steuergerät ist dazu eingerichtet, bei einem Anschalten des organischen lichtemittierenden Bauelements an das organische lichtemittierende Bauelement eine Wechselspannung anzulegen, die kleiner als eine aktuelle Schwellenspannung des organischen lichtemittierenden Bauelements ist, und nach dem Anschalten des organischen lichtemittierenden Bauelements an das organische lichtemittierende Bauelement eine Gleichspannung anzulegen, die größer als die aktuelle Schwellenspannung des organischen lichtemittierenden Bauelements ist, falls der Messwert gleich wie oder größer als ein vorgegebener Schwellenwert ist.

Somit wird bei jedem Anschalten des organischen lichtemittierenden Bauelements, insbesondere unabhängig von der aktuellen Temperatur, das organische lichtemittierende Bauelement zumindest kurz mit der Wechselspannung betrieben. Dadurch kann grundsätzlich beim Anschalten ein Aufheizvorgang initiiert werden. Der Aufheizvorgang wird jedoch immer so durchgeführt, dass die Wechselspannung vollständig unter der aktuellen Schwellenspannung des organischen lichtemittierenden Bauelements liegt, so dass das organische lichtemittierende Bauelement während des Aufheizens nicht leuchtet, was die bereits im Vorhergehenden erläuterten Vorteile hat.

Die optoelektronische Baugruppe weist einen Temperatursensor zum Erfassen eines Temperaturwerts auf, wobei der der Messwert der Temperaturwert ist und der Schwellenwert ein vorgegebener Temperaturschwellenwert ist. Dies kann auf einfache Weise dazu beitragen, zu erkennen, wann der Aufheizvorgang beendet werden kann und der normale Betrieb, insbesondere der Leuchtbetrieb, des organischen lichtemittierenden Bauelements aufgenommen werden kann.

Alternativ weist die optoelektronische Baugruppe einen Stromsensor zum Erfassen eines Stromwerts eines Vorwärtsstroms auf, der über das organische lichtemittierende Bauelement fließt, wobei der Messwert der Stromwert ist und der Schwellenwert ein vorgegebener Stromschwellenwert ist. Dies kann dazu beitragen, auf einfache Weise zu erkennen, wann der Aufheizvorgang beendet werden kann und der normale Betrieb, insbesondere der Leuchtbetrieb, des organischen lichtemittierenden Bauelements aufgenommen werden kann. Der vorgegebene Stromschwellenwert kann beispielsweise werkseitig empirisch ermittelt und auf einem Speichermedium der optoelektronischen Baugruppe gespeichert werden.

Alternativ weist die optoelektronische Baugruppe eine Uhr zum Erfassen einer Zeitdauer auf, die seit dem Anschalten des organischen lichtemittierenden Bauelements vergangen ist, wobei der Messwert der Zeitdauer entspricht und der Schwellenwert ein vorgegebener Zeitschwellenwert ist. Dies kann auf einfache Weise dazu beitragen, zu erkennen, wann der Aufheizvorgang beendet werden kann und der normale Betrieb, insbesondere der Leuchtbetrieb, des organischen lichtemittierenden Bauelements aufgenommen werden kann. Der vorgegebene Zeitschwellenwert kann beispielsweise werkseitig empirisch ermittelt und auf einem Speichermedium der optoelektronischen Baugruppe gespeichert werden.

Eine Aufgabe wird gemäß einem Aspekt der Erfindung gelöst durch ein Verfahren zum Betreiben einer optoelektronischen Baugruppe, die ein organisches lichtemittierendes Bauelement aufweist. Bei dem Verfahren wird bei einem Anschalten des organischen lichtemittierenden Bauelements der Temperaturwert erfasst. Die Wechselspannung, die zumindest zeitweise kleiner als eine aktuelle Schwellenspannung des organischen lichtemittierenden Bauelements ist, wird an das organische lichtemittierende Bauelement angelegt, falls der erfasste Temperaturwert kleiner als der vorgegebene Temperaturschwellenwert ist. An das organische lichtemittierende Bauelement wird die Gleichspannung angelegt, die größer als die aktuelle Schwellenspannung des organischen lichtemittierenden Bauelements ist, falls der Messwert gleich wie oder größer als der vorgegebene Schwellenwert ist.

Bei einer Weiterbildung ist die Wechselspannung immer kleiner als die aktuelle Schwellenspannung des organischen lichtemittierenden Bauelements, was die im Vorhergehenden beschriebenen Vorteile hat.

Der Messwert ist ein weiterer Temperaturwert und der Schwellenwert ist der Temperaturschwellenwert, was die im Vorhergehenden beschriebenen Vorteile hat.

Eine Aufgabe wird gemäß einem Aspekt der Erfindung gelöst durch ein Verfahren zum Betreiben einer optoelektronischen Baugruppe, die ein organisches lichtemittierendes Bauelement aufweist. Bei dem Verfahren wird bei dem Anschalten des organischen lichtemittierenden Bauelements an das organische lichtemittierende Bauelement die Wechselspannung angelegt, die kleiner als die aktuelle Schwellenspannung des organischen lichtemittierenden Bauelements ist. Nach dem Anschalten des organischen lichtemittierenden Bauelements wird der Messwert erfasst und an das organische lichtemittierende Bauelement wird die Gleichspannung angelegt, die größer als die aktuelle Schwellenspannung des organischen lichtemittierenden Bauelements ist, falls der Messwert gleich wie oder größer als ein vorgegebener Schwellenwert ist.

Der Messwert ist der Temperaturwert und der Schwellenwert ist der vorgegebene Temperaturschwellenwert.

Alternativ ist der Messwert der Stromwert des Vorwärtsstroms, der über das organische lichtemittierende Bauelement fließt, und der Schwellenwert ist der vorgegebene Stromschwellenwert.

Alternativ entspricht der Messwert einer Zeitdauer, die seit dem Anschalten des organischen lichtemittierenden Bauelements vergangen ist, und der Schwellenwert ist der vorgegebene Zeitschwellenwert.

Bei einer Weiterbildung wird die Wechselspannung so gewählt, dass ein Effektivstromwert des dadurch verursachten Wechselstroms größer ist als der Stromwert des Gleichstroms, der durch die Gleichspannung verursacht wird. Dies kann zu einem besonders schnellen und/oder effektiven Aufheizen des organischen lichtemittierenden Bauelements beitragen. Der Effektivwert kann auch als RMS-Wert oder quadratischer Mittelwert bezeichnet werden.

Ausführungsbeispiele der Erfindung sind in den Figuren dargestellt und werden im Folgenden näher erläutert.

Es zeigen:
- Figur 1: eine Schnittdarstellung eines Ausführungsbeispiels eines organischen lichtemittierenden Bauelements;
- Figur 2: ein Ersatzschaltbild des organischen lichtemittierenden Bauelements gemäß Figur 1,
- Figur 3: ein Beispiel eines Temperatur-Spannung-Diagramms,
- Figur 4: ein Beispiel eines Zeit-Temperaturunterschied-Diagramms,
- Figur 5: ein Blockschaltbild eines Ausführungsbeispiels einer optoelektronischen Baugruppe,
- Figur 6: ein Beispiel eines Zeit-Spannung-Diagramms,
- Figur 7: ein Ablaufdiagramm eines Ausführungsbeispiels eines Verfahrens zum Betreiben einer optoelektronischen Baugruppe,
- Figur 8: ein Beispiel eines Zeit-Spannung-Diagramms,
- Figur 9: ein Ablaufdiagramm eines Ausführungsbeispiels eines Verfahrens zum Betreiben einer optoelektronischen Baugruppe.

In der folgenden ausführlichen Beschreibung wird auf die beigefügten Zeichnungen Bezug genommen, die Teil dieser Beschreibung bilden und in denen zur Veranschaulichung spezifische Ausführungsbeispiele gezeigt sind, in denen die Erfindung ausgeübt werden kann. Da Komponenten von Ausführungsbeispielen in einer Anzahl verschiedener Orientierungen positioniert werden können, dient die Richtungsterminologie zur Veranschaulichung und ist auf keinerlei Weise einschränkend. Es versteht sich, dass andere Ausführungsbeispiele benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen Ausführungsbeispiele miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert. In den Figuren sind identische oder ähnliche Elemente mit identischen Bezugszeichen versehen, soweit dies zweckmäßig ist.

Eine optoelektronische Baugruppe kann ein, zwei oder mehr organische lichtemittierende Bauelemente aufweisen. Optional kann eine optoelektronische Baugruppe auch ein, zwei oder mehr elektronische Bauelemente aufweisen. Ein elektronisches Bauelement kann beispielsweise ein aktives und/oder ein passives Bauelement aufweisen. Ein aktives elektronisches Bauelement kann beispielsweise eine Rechen-, Sensor-, Steuer- und/oder Regeleinheit und/oder einen Transistor aufweisen. Ein passives elektronisches Bauelement kann beispielsweise einen Kondensator, einen Widerstand, eine Diode oder eine Spule aufweisen.

Ein organisches lichtemittierendes Bauelement kann in verschiedenen Ausführungsbeispielen ein organisches lichtemittierendes Halbleiter-Bauelement sein und/oder als eine organische lichtemittierende Diode, insbesondere als OLED (organic light emitting diode) oder als ein organischer lichtemittierender Transistor ausgebildet sein. Das Licht kann beispielsweise Licht im sichtbaren Bereich, UV-Licht und/oder Infrarot-Licht sein. Das organische lichtemittierende Bauelement kann in verschiedenen Ausführungsbeispielen Teil einer integrierten Schaltung sein. Weiterhin kann eine Mehrzahl von organischen lichtemittierenden Bauelementen vorgesehen sein, beispielsweise untergebracht in einem gemeinsamen Gehäuse der optoelektronischen Baugruppe.

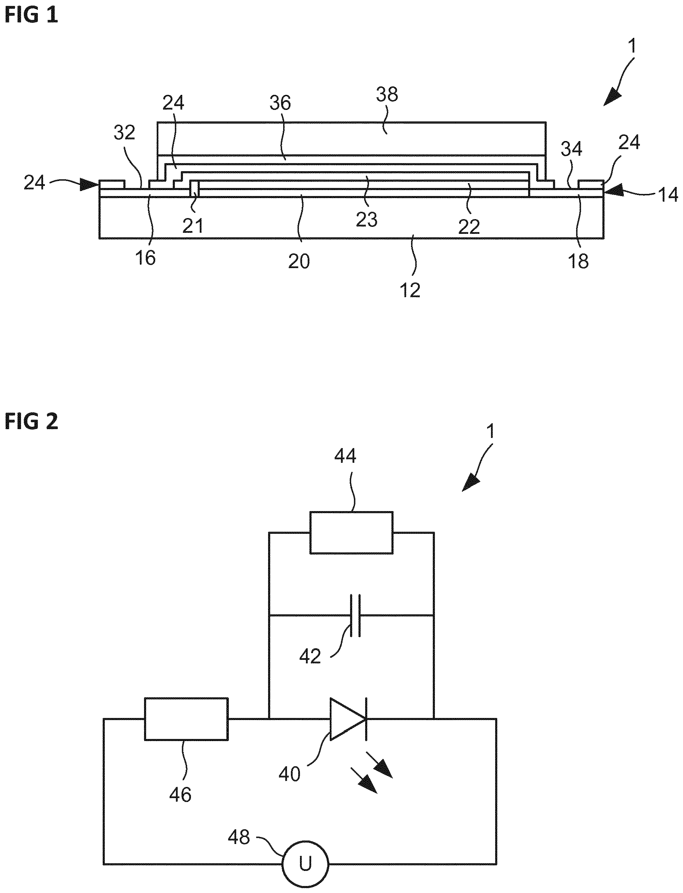

**Fig. 1** zeigt ein Ausführungsbeispiel eines optoelektronischen Bauelements 1. Das optoelektronische Bauelement 1 weist einen Träger 12 auf. Der Träger 12 kann transluzent oder transparent ausgebildet sein. Der Träger 12 dient als Trägerelement für elektronische Elemente oder Schichten, beispielsweise lichtemittierende Elemente. Der Träger 12 kann beispielsweise Kunststoff, Metall, Glas, Quarz und/oder ein Halbleitermaterial aufweisen oder daraus gebildet sein. Ferner kann der Träger 12 eine Kunststofffolie oder ein Laminat mit einer oder mit mehreren Kunststofffolien aufweisen oder daraus gebildet sein. Der Träger 12 kann mechanisch rigide oder mechanisch flexibel ausgebildet sein.

Auf dem Träger 12 ist eine optoelektronische Schichtenstruktur ausgebildet. Die optoelektronische Schichtenstruktur weist eine erste Elektrodenschicht 14 auf, die einen ersten Kontaktabschnitt 16, einen zweiten Kontaktabschnitt 18 und eine erste Elektrode 20 aufweist. Der Träger 12 mit der ersten Elektrodenschicht 14 kann auch als Substrat bezeichnet werden. Zwischen dem Träger 12 und der ersten Elektrodenschicht 14 kann eine erste nicht dargestellte Barriereschicht, beispielsweise eine erste Barrieredünnschicht, ausgebildet sein.

Die erste Elektrode 20 ist von dem ersten Kontaktabschnitt 16 mittels einer elektrischen Isolierungsbarriere 21 elektrisch isoliert. Der zweite Kontaktabschnitt 18 ist mit der ersten Elektrode 20 der optoelektronischen Schichtenstruktur elektrisch gekoppelt. Die erste Elektrode 20 kann als Anode oder als Kathode ausgebildet sein. Die erste Elektrode 20 kann transluzent oder transparent ausgebildet sein. Die erste Elektrode 20 weist ein elektrisch leitfähiges Material auf, beispielsweise Metall und/oder ein leitfähiges transparentes Oxid (transparent conductive oxide, TCO) oder einen Schichtenstapel mehrerer Schichten, die Metalle oder TCOs aufweisen. Die erste Elektrode 20 kann beispielsweise einen Schichtenstapel einer Kombination einer Schicht eines Metalls auf einer Schicht eines TCOs aufweisen, oder umgekehrt. Ein Beispiel ist eine Silberschicht, die auf einer Indium-ZinnOxid-Schicht (ITO) aufgebracht ist (Ag auf ITO) oder ITO-Ag-ITO Multischichten. Die erste Elektrode 20 kann alternativ oder zusätzlich zu den genannten Materialien aufweisen: Netzwerke aus metallischen Nanodrähten und -teilchen, beispielsweise aus Ag, Netzwerke aus Kohlenstoff-Nanoröhren, Graphen-Teilchen und -Schichten und/oder Netzwerke aus halbleitenden Nanodrähten.

Über der ersten Elektrode 20 ist eine optisch funktionelle Schichtenstruktur, beispielsweise eine organische funktionelle Schichtenstruktur 22, der optoelektronischen Schichtenstruktur ausgebildet. Die organische funktionelle Schichtenstruktur 22 kann beispielsweise eine, zwei oder mehr Teilschichten aufweisen. Beispielsweise kann die organische funktionelle Schichtenstruktur 22 eine Lochinjektionsschicht, eine Lochtransportschicht, eine Emitterschicht, eine Elektronentransportschicht und/oder eine Elektroneninjektionsschicht aufweisen. Die Lochinjektionsschicht dient zum Reduzieren der Bandlücke zwischen erster Elektrode und Lochtransportschicht. Bei der Lochtransportschicht ist die Lochleitfähigkeit größer als die Elektronenleitfähigkeit. Die Lochtransportschicht dient zum Transportieren der Löcher. Bei der Elektronentransportschicht ist die Elektronenleitfähigkeit größer als die Lochleitfähigkeit. Die Elektronentransportschicht dient zum Transportieren der Löcher. Die Elektroneninjektionsschicht dient zum Reduzieren der Bandlücke zwischen zweiter Elektrode und Elektronentransportschicht. Ferner kann die organische funktionelle Schichtenstruktur 22 ein, zwei oder mehr funktionelle Schichtenstruktur-Einheiten, die jeweils die genannten Teilschichten und/oder weitere Zwischenschichten aufweisen.

Über der organischen funktionellen Schichtenstruktur 22 ist eine zweite Elektrode 23 der optoelektronischen Schichtenstruktur ausgebildet, die elektrisch mit dem ersten Kontaktabschnitt 16 gekoppelt ist. Die zweite Elektrode 23 kann gemäß einer der Ausgestaltungen der ersten Elektrode 20 ausgebildet sein, wobei die erste Elektrode 20 und die zweite Elektrode 23 gleich oder unterschiedlich ausgebildet sein können. Die erste Elektrode 20 dient beispielsweise als Anode oder Kathode der optoelektronischen Schichtenstruktur. Die zweite Elektrode 23 dient korrespondierend zu der ersten Elektrode als Kathode bzw. Anode der optoelektronischen Schichtenstruktur.

Die optoelektronische Schichtenstruktur ist ein elektrisch und/oder optisch aktiver Bereich. Der aktive Bereich ist beispielsweise der Bereich des optoelektronischen Bauelements 10, in dem elektrischer Strom zum Betrieb des optoelektronischen Bauelements 10 fließt und/oder in dem elektromagnetische Strahlung erzeugt oder absorbiert wird. Auf oder über dem aktiven Bereich kann eine Getter-Struktur (nicht dargestellt) angeordnet sein. Die Getter-Schicht kann transluzent, transparent oder opak ausgebildet sein. Die Getter-Schicht kann ein Material aufweisen oder daraus gebildet sein, das Stoffe, die schädlich für den aktiven Bereich sind, absorbiert und bindet.

Über der zweiten Elektrode 23 und teilweise über dem ersten Kontaktabschnitt 16 und teilweise über dem zweiten Kontaktabschnitt 18 ist eine Verkapselungsschicht 24 der optoelektronische Schichtenstruktur ausgebildet, die die optoelektronische Schichtenstruktur verkapselt. Die Verkapselungsschicht 24 kann als zweite Barriereschicht, beispielsweise als zweite Barrieredünnschicht, ausgebildet sein. Die Verkapselungsschicht 24 kann auch als Dünnschichtverkapselung bezeichnet werden. Die Verkapselungsschicht 24 bildet eine Barriere gegenüber chemischen Verunreinigungen bzw. atmosphärischen Stoffen, insbesondere gegenüber Wasser (Feuchtigkeit) und Sauerstoff. Die Verkapselungsschicht 24 kann als eine einzelne Schicht, ein Schichtstapel oder eine Schichtstruktur ausgebildet sein. Die Verkapselungsschicht 24 kann aufweisen oder daraus gebildet sein: Aluminiumoxid, Zinkoxid, Zirkoniumoxid, Titanoxid, Hafniumoxid, Tantaloxid Lanthaniumoxid, Siliziumoxid, Siliziumnitrid, Siliziumoxinitrid, Indiumzinnoxid, Indiumzinkoxid, Aluminium-dotiertes Zinkoxid, Poly(p-phenylenterephthalamid), Nylon 66, sowie Mischungen und Legierungen derselben. Gegebenenfalls kann die erste Barriereschicht auf dem Träger 12 korrespondierend zu einer Ausgestaltung der Verkapselungsschicht 24 ausgebildet sein.

In der Verkapselungsschicht 24 sind über dem ersten Kontaktabschnitt 16 eine erste Ausnehmung der Verkapselungsschicht 24 und über dem zweiten Kontaktabschnitt 18 eine zweite Ausnehmung der Verkapselungsschicht 24 ausgebildet. In der ersten Ausnehmung der Verkapselungsschicht 24 ist ein erster Kontaktbereich 32 freigelegt und in der zweiten Ausnehmung der Verkapselungsschicht 24 ist ein zweiter Kontaktbereich 34 freigelegt. Der erste Kontaktbereich 32 dient zum elektrischen Kontaktieren des ersten Kontaktabschnitts 16 und der zweite Kontaktbereich 34 dient zum elektrischen Kontaktieren des zweiten Kontaktabschnitts 18.

Über der Verkapselungsschicht 24 ist eine Haftmittelschicht 36 ausgebildet. Die Haftmittelschicht 36 weist beispielsweise ein Haftmittel, beispielsweise einen Klebstoff, beispielsweise einen Laminierklebstoff, einen Lack und/oder ein Harz auf. Die Haftmittelschicht 36 kann beispielsweise Partikel aufweisen, die elektromagnetische Strahlung streuen, beispielsweise lichtstreuende Partikel.

Über der Haftmittelschicht 36 ist ein Abdeckkörper 38 ausgebildet. Die Haftmittelschicht 36 dient zum Befestigen des Abdeckkörpers 38 an der Verkapselungsschicht 24. Der Abdeckkörper 38 weist beispielsweise Kunststoff, Glas und/oder Metall auf. Beispielsweise kann der Abdeckkörper 38 im Wesentlichen aus Glas gebildet sein und eine dünne Metallschicht, beispielsweise eine Metallfolie, und/oder eine Graphitschicht, beispielsweise ein Graphitlaminat, auf dem Glaskörper aufweisen. Der Abdeckkörper 38 dient zum Schützen des herkömmlichen optoelektronischen Bauelements 1, beispielsweise vor mechanischen Krafteinwirkungen von außen. Ferner kann der Abdeckkörper 38 zum Verteilen und/oder Abführen von Hitze dienen, die in dem herkömmlichen optoelektronischen Bauelement 1 erzeugt wird. Beispielsweise kann das Glas des Abdeckkörpers 38 als Schutz vor äußeren Einwirkungen dienen und die Metallschicht des Abdeckkörpers 38 kann zum Verteilen und/oder Abführen der beim Betrieb des herkömmlichen optoelektronischen Bauelements 1 entstehenden Wärme dienen.

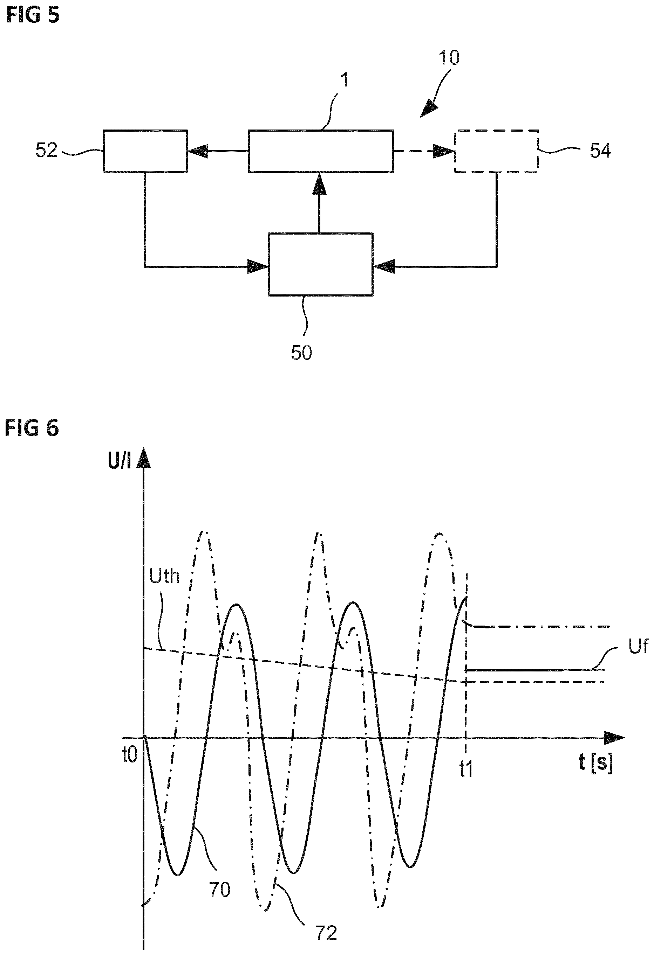

**Fig. 2** zeigt ein Ersatzschaltbild des organischen lichtemittierenden Bauelements 1 gemäß Figur 1. Die organische funktionelle Schichtenstruktur 23 ist aufgrund ihres diodenartigen Verhaltens als Diode 40 dargestellt. Zusätzlich zu der Diode 40 weist das Ersatzschaltbild einen Kondensator 42 und einen Bulkwiderstand 44 auf, die parallel zu der Diode 40 und parallel zueinander geschaltet sind. Der Kondensator 42 ist von den Elektroden 20, 23 gebildet. Der Bulkwiderstand 44 ist repräsentativ für einen oder mehrere elektrische Widerstände von einem oder entsprechend mehreren Leckstrompfaden zwischen den Elektroden 20, 23. Außerdem weist das Ersatzschaltbild einen Elektrodenwiderstand 46 auf, der zu der Diode 40, dem Kondensator 42 und dem Bulkwiderstand 44 in Reihe geschaltet ist und der repräsentativ ist für die elektrischen Widerstände der beiden Elektroden 20, 23 oder für den elektrischen Widerstand der ersten Elektrode 20, falls der elektrische Widerstand der zweiten Elektrode vernachlässigt wird. Zusätzlich ist eine Spannungsquelle 48 dargestellt. Die Spannungsquelle 48 kann beispielsweise Teil eines Steuergeräts sein, das nachfolgend mit Bezug zu Figur 5 näher erläutert wird.

Wird nun mittels der Spannungsquelle 48 eine Spannung, beispielsweise eine Gleichspannung, an den Elektrodenwiderstand 46 und die Diode 40 angelegt, die größer als eine aktuelle Schwellenspannung der Diode 40 ist, so beginnt der normale Betrieb der Diode 40, die Diode 40 wird leitend und die organische funktionelle Schichtenstruktur 23 emittiert Licht.

Wird mittels der Spannungsquelle 48 eine Spannung an den Elektrodenwiderstand 46 und die Diode 40 angelegt, die kleiner als die aktuelle Schwellenspannung der Diode 40 ist, so wird die Diode 40 nicht leitend und für die Funktion des organischen lichtemittierenden Bauelements 1 kann man sich die Diode 40 aus dem Ersatzschaltbild wegdenken. Es bleiben die restlichen parasitären Elemente des Ersatzschaltbildes übrig, insbesondere der Elektrodenwiderstand 46, der Kondensator 42 und der Bulkwiderstand 44.

Interessant ist hierbei insbesondere der Kondensator 42. Dieser ist für den Gleichstrom, insbesondere im normalen Betrieb des organischen lichtemittierenden Bauelements 1, undurchlässig, stellt jedoch für Wechselstrom nur einen Wechselstromwiderstand dar. Dieser Wechselstromwiderstand ist umso niedriger, je höher die Kapazität ist und/oder je höher die Frequenz der Wechselspannung ist. Macht man also den Kondensator 42 als Wechselstromwiderstand mit einer Wechselspannung mit einer hohen Frequenz sehr niederohmig, so kann man auch mit einer kleinen Wechselspannung, also einer Wechselspannung mit kleiner Amplitude, das organische lichtemittierende Bauelement 1 mit einem hohen Wechselstrom betreiben. Dieser Wechselstrom fließt zwangsweise aufgrund der Reihenschaltung über den Elektrodenwiderstand 46 und verursacht dort einen Spannungsabfall und Wärmeverlust. Dadurch erwärmt sich direkt die erste Elektrode 20 und indirekt mittels der ersten Elektrode 20 die organischen funktionelle Schichtenstruktur 22. Diese Erwärmung ist sehr effizient und erfolgt "von innen heraus". Dieser Effekt kann beim Anschalten des organischen lichtemittierenden Bauelements 1 als Aufheizvorgang vor dem normalen Betrieb des organischen lichtemittierenden Bauelements 1 genutzt werden.

Ist die Wechselspannung auch bei maximaler Amplitude kleiner als die aktuelle Schwellenspannung des organischen lichtemittierenden Bauelements 1, so fließt nur ein vernachlässigbar geringer Strom oder überhaupt kein Strom über die organische funktionelle Schichtenstruktur 22. Ist die Wechselspannung bei maximaler Amplitude etwas größer als die aktuelle Schwellenspannung, so fließt zumindest zeitweise Strom über die organische funktionelle Schichtenstruktur 22.

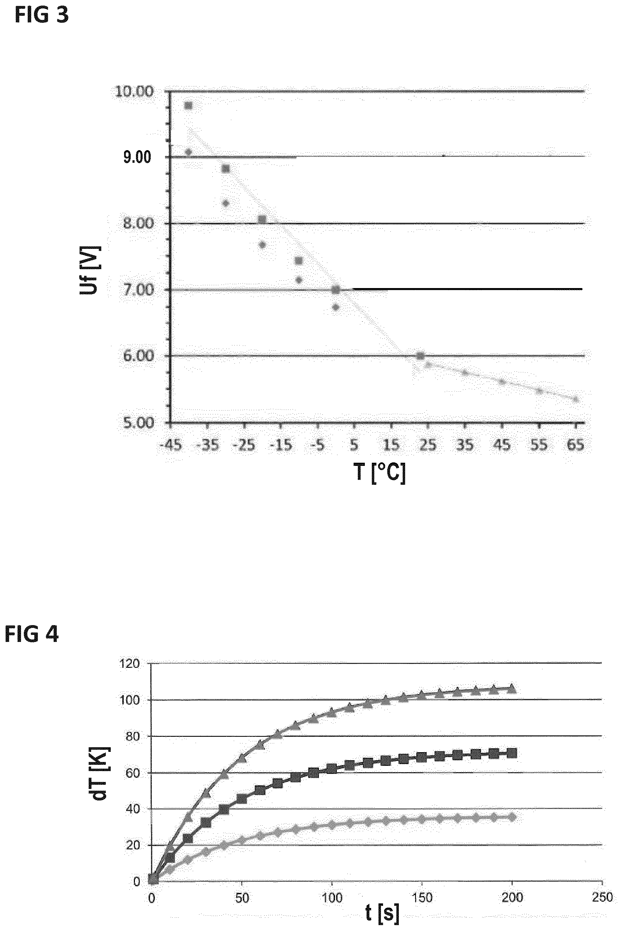

**Fig. 3** zeigt ein Temperatur-Spannung-Diagramm, in dem Vorwärtsspannungen in dem normalen Betrieb, also im Leuchtbetrieb, des organischen lichtemittierenden Bauelements 1 in Abhängigkeit von einer Außentemperatur T einer Umgebung des organischen lichtemittierenden Bauelements 1 dargestellt sind. Insbesondere sind die quadratischen Messpunkte repräsentativ für Werte der Vorwärtsspannung bei den entsprechenden Außentemperaturen T beim Einschalten der entsprechenden OLED. Die dreieckigen Messpunkte sind repräsentativ für Werte der Vorwärtsspannung bei den entsprechenden Außentemperaturen T nach einer vorgegebenen Zeitdauer, beispielsweise nach ein paar Minuten, nach dem Einschalten der entsprechenden OLED. Die rautenförmigen Messpunkte sind repräsentativ für Werte der Vorwärtsspannung bei den entsprechenden Temperaturen beim Einschalten der entsprechenden OLED und nach der vorgegebenen Zeitdauer, da sich bei diesen Temperaturen, die Werte nicht mehr wesentlich und/oder nicht mehr merklich voneinander unterscheiden. Die OLED entspricht im Wesentlichen dem im Vorhergehenden erläuterten organischen lichtemittierenden Bauelement 1.

Das Temperatur-Spannung-Diagramm zeigt, dass mit abnehmender Außentemperatur T die beim Einschalten für den normalen Betrieb benötigte Vorwärtsspannung ansteigt und dass während des Betriebs der OLED bei gleichbleibender Außentemperatur und mit zunehmender Eigentemperatur die für den normalen Betrieb benötigte Vorwärtsspannung abnimmt. Ohne ein Aufheizen der OLED wäre zum Betreiben der OLED im gesamten Temperaturbereich ein Steuergerät notwendig, das in der Lage ist, den gesamten dargestellten Bereich von Vorwärtsspannungen bereitzustellen, auch wenn die besonders niedrigen Temperaturen, beispielsweise unter -15°C nur selten auftreten. Ein derartiges Steuergerät wäre relativ teuer.

Falls mehrere OLEDs in Reihe geschaltet sind, so multipliziert sich dieser Effekt um die Anzahl der in Reihe geschalteten OLEDs. Sind beispielsweise zehn OLEDs in Reihe geschaltet, deren benötigte Vorwärtsspannung mittels des Aufheizens jeweils um 1V abgesenkt wird, so ist insgesamt eine um 10V geringere Spannung nötig, um die in Reihe geschalteten OLEDs normal betreiben zu können.

Im Automotive-Bereich sind Situationen bekannt, bei denen die Boardspannung auf 9V abfällt, beispielsweise beim Anlassen eines KFZs. Diese niedrige Boardspannung könnte bei Kälte evtl. nicht mehr ausreichend sein, um eine OLED oder zwei oder mehr in Reihe geschaltete OLEDs normal betreiben zu können. Falls die OLEDs beispielsweise als Rücklichter verwendet werden, so wäre dies nicht akzeptabel. Allerdings kann mit 9V Wechselspannung schon ein sehr hoher Wechselstrom, insbesondere ein sehr hoher Effektivstromwert des Wechselstroms erreicht werden, wodurch eine sehr schnelle Aufwärmung möglich ist, mittels der die Schwellenwertspannungen der beteiligten OLEDs schnell abgesenkt werden können, so dass diese auch mit der niedrigen Boardspannung betrieben werden können.

**Fig. 4** zeigt ein Zeit-Wärmeunterschied-Diagramm, bei dem für unterschiedliche elektrische Leistungen der Wärmeunterschied in Abhängigkeit der Zeit angegeben ist. Insbesondere wurden die rautenförmigen Messpunkte bei einer Leistung von 2 W, die quadratischen Messpunkte bei einer Leistung von 4 W und die dreieckigen Messpunkte bei einer Leistung von 6 W erfasst. Das Zeit-Wärmeunterschied-Diagramm zeigt, dass die Zeit, innerhalb der in dem organischen lichtemittierenden Bauelement 1 eine gewünschte Wärmeänderung erzielt werden kann, von der eingebrachten elektrischen Leistung abhängt.

Beträgt die normale Leistung der OLED beispielsweise 2 W, so würde sich die OLED eingependelt, also ca. nach 160 s um 35°C erhitzen. Prägt man jedoch nach dem Anschalten der OLED und vor dem normalen Betrieb der OLED eine Wärmeleistung von beispielsweise 6 W ein, so werden die gewünschten 35°C schon nach ca. 20 s erzielt. Danach kann der normale Betrieb begonnen werden. Somit kann aufgrund des Aufheizvorgangs mittels der Wechselspannung der normale Betrieb schon 120 s früher als ohne Aufheizen begonnen werden.

**Fig. 5** zeigt ein Blockschaltbild eines Ausführungsbeispiels einer optoelektronischen Baugruppe 10. Die optoelektronische Baugruppe 10 weist ein organisches lichtemittierendes Bauelement, beispielsweise das im Vorhergehenden erläuterte organische lichtemittierende Bauelement 1, ein Steuergerät 50, einen ersten Sensor 52 und optional einen zweiten Sensor 54 auf. Das Steuergerät 50 kann beispielsweise ein Treiber sein. Der erste Sensor 52 ist ein Temperatursensor. Der erste Sensor 52 dient dazu, einen Temperaturwert zu erfassen. Der Temperaturwert ist repräsentativ für eine Temperatur des organischen lichtemittierenden Bauelements 1, insbesondere die organische funktionelle Schichtenstruktur 22, und/oder einer Umgebung des organischen lichtemittierenden Bauelements 1. Alternativ dazu kann der erste Sensor 52 ein Stromsensor zum Erfassen eines Stromwerts eines Vorwärtsstroms, der über das organische lichtemittierende Bauelement 1 fließt, sein oder eine Uhr zum Erfassen eines Zeitwerts einer Zeitdauer, die seit dem Anschalten des organischen lichtemittierenden Bauelements 1 vergangen ist. Gegebenenfalls und beispielsweise, wenn der erste Sensor 52 der Temperatursensor ist, kann der zweite Sensor 54 der Stromsensor oder die Uhr sein. Ferner kann die optoelektronische Baugruppe 10 ein nicht dargestelltes Speichermedium aufweisen.

Das Steuergerät 50 dient dazu, die mittels der Sensoren 52, 54 erfassten Messwerte zu verarbeiten und abhängig von den erfassten Messwerten das organische lichtemittierende Bauelement 1 zu steuern und/oder zu regeln. Insbesondere dient das Steuergerät 50 dazu, das organische lichtemittierende Bauelement 1 anzuschalten und vor dem normalen Betrieb aufzuheizen und dann im normalen Betrieb zu betreiben oder das organische lichtemittierende Bauelement anzuschalten und nur falls nötig vor dem normalen Betrieb aufzuheizen und dann im normalen Betrieb zu betreiben.

Das Aufheizen kann von dem Steuergerät 50 beispielsweise als nötig erkannt werden, wenn der erfasste Temperaturwert kleiner als ein vorgegebener Temperaturschwellenwert ist.

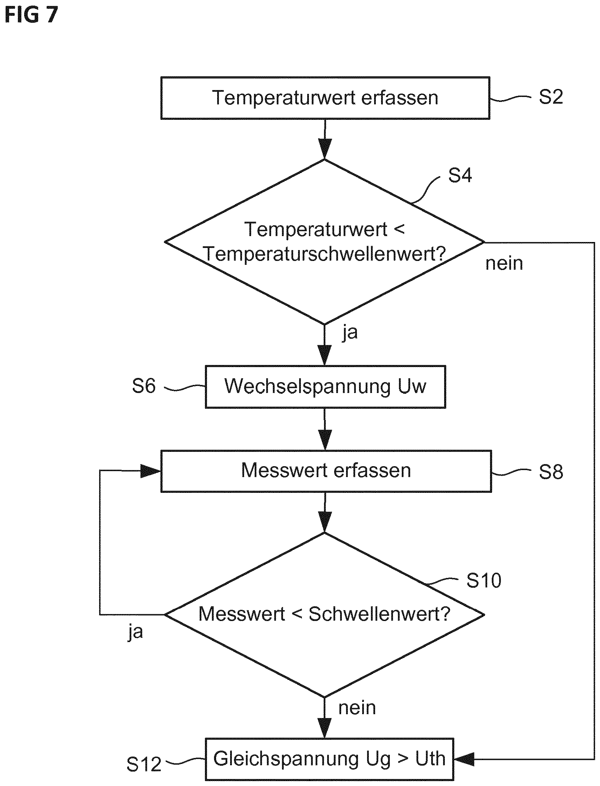

**Fig. 6** und **Fig. 7** dienen gemeinsam zum Erläutern eines Ausführungsbeispiels eines Verfahrens zum Betreiben einer optoelektronischen Baugruppe, beispielsweise der im Vorhergehenden erläuterten optoelektronischen Baugruppe 10.

Figur 6 zeigt ein Zeit-Spannung-Diagramm, in dem ein erster Spannungsverlauf 70 einer Wechselspannung, die in einer Aufwärmphase an das organische lichtemittierende Bauelement 1 angelegt wird, und eine Vorwärtsspannung Uf, die im normalen Betrieb an das organische lichtemittierende Bauelement 1 angelegt wird, als durchgezogene Linie dargestellt sind. Des Weiteren ist eine aktuelle Schwellenspannung Uth als gestrichelte Linie dargestellt. In Figur 6 nimmt die aktuelle Schwellenspannung Uth während der Aufwärmphase mit der Zeit ab, da die Eigentemperatur des organischen lichtemittierenden Bauelements 1 zunimmt.

Neben den erwähnten Spannungen ist in dem in Figur 6 gezeigten Diagramm als Strich-Punkt-Linie ein erster Stromverlauf 72 des Stroms dargestellt, mit dem das organische lichtemittierende Bauelement 1 betrieben wird.

Die dargestellte Schwingung der Wechselspannung beginnt kurz nach einem Zeitpunkt t0, an dem das organische lichtemittierende Bauelement 1 eingeschaltet wurde und erkannt wurde, dass die Temperatur des organischen lichtemittierenden Bauelements 1 derart gering ist, dass es vor Aufnahme des normalen Betriebs aufgeheizt werden muss. Es wird die Aufwärmphase initiiert. Die Wechselspannung wird bis zu einem Zeitpunkt t1 angelegt, an dem erkannt wird, dass ein weiteres Aufheizen des organischen lichtemittierenden Bauelements 1 nicht mehr nötig ist. Die Aufwärmphase wird beendet. Zum Zeitpunkt t1 wird eine Gleichspannung, insbesondere die Vorwärtsspannung Uf an das organische lichtemittierende Bauelement 1 angelegt. Die Vorwärtsspannung Uf ist kleiner als die aktuelle Schwellenspannung Uth zum Zeitpunkt t0 und ist größer als die aktuelle Schwellenspannung Uth zum Zeitpunkt t1 und danach.

Der erste Stromverlauf 72 folgt dem ersten Spannungsverlauf 70. Der erste Stromverlauf 72 folgt dem ersten Spannungsverlauf 70 in den Zeitabschnitten, in denen die Wechselspannung kleiner als die aktuelle Schwellenspannung Uth ist und in denen kein Strom über die organische funktionelle Schichtenstruktur 22 fließt und kein Licht emittiert wird, mit einer Phasenverschiebung von ungefähr 90°. Der erste Stromverlauf 72 folgt dem ersten Spannungsverlauf 70 in den Zeitabschnitten, in denen die Wechselspannung größer als die aktuelle Schwellenspannung Uth ist und in denen somit Strom über die organische funktionelle Schichtenstruktur 22 fließt und Licht emittiert wird, ohne signifikante Phasenverschiebung. Nach Anlegen der Gleichspannung zum Zeitpunkt t1 und Beginn des normalen Betriebs fließt Gleichstrom über das organische lichtemittierende Bauelement 1. Die maximale Amplitude des ersten Stromverlaufs 72 vor dem Zeitpunkt t1, also während der Aufwärmphase, ist größer als der konstante Wert des ersten Stromverlaufs nach dem Zeitpunkt t1, also im Normal- oder Nennbetrieb. Dies kann dazu beitragen, dass der Effektivstromwert während der Aufwärmphase besonders hoch ist, wodurch eine besonders schnelle Aufwärmung erfolgt.

Der erste Spannungsverlauf 70 ist sinusförmig. Alternativ dazu kann der erste Spannungsverlauf 70 beispielsweise sägezahnförmig oder trapezförmig und/oder bipolar oder unipolar sein. Die Wechselspannung ist hochfrequent, beispielsweise im Kilohertz- bis Megahertz-Bereich. Die Wechselspannung kann abhängig von der Kapazität des Kondensator 42, des Elektrodenwiderstands 46 und/oder der Schwellenspannung Uth des organischen lichtemittierenden Bauelements 1 ausgelegt werden. Der erste Spannungsverlauf 70 verläuft vorzugsweise weitgehend unterhalb der aktuellen Schwellenspannung Uth, kann aber die aktuelle Schwellenspannung Uth auch überschreiten. Insbesondere kann die maximale Amplitude des ersten Spannungsverlaufs 70 die aktuelle Schwellenspannung Uth überschreiten. Ersteres ist beispielsweise besonders geeignet für OLEDs mit hoher Schwellenspannung Uth, beispielsweise für OLEDs mit mehrfach gestapelten organischen funktionellen Schichtenstrukturen 22, da diese bei besonders kleiner Frequenz mit einem besonders hohen Strom aufgeheizt werden können.

Die Heizleistung kann beispielsweise so gewählt werden, dass das lichtemittierende Bauelement 1 besonders schnell jedoch nicht unnötig hoch erwärmt wird. Beispielsweise kann eine maximale gewünschte Temperaturänderung so gewählt werden, dass sie der Temperaturänderung im normalen Betrieb des organischen lichtemittierenden Bauelements 1 entspricht, die sich nach ausreichend langer Zeit stationär einstellt. Diese Temperaturänderung kann beispielsweise werkseitig empirisch ermittelt werden. Die Heizenergie kann über die Frequenz, die Spannungsamplitude und die Zeitdauer des Heizens eingestellt werden. Bevorzugt werden Spannung und Frequenz so gewählt, dass die Stromamplitude und/oder der Effektivstromwert des Wechselstroms größer sind als der Stromwert des Gleichstroms im Normal- oder Nennbetrieb. Beispielsweise kann der Effektivwert des Wechselstroms im Bereich des ein- bis zwanzigfachen Nennstroms, beispielsweise im Bereich des dreibis fünfzehnfachen Nennstroms oder im Bereich des fünf- bis zehnfachen Nennstroms liegen. Der Nennbetriebsstrom kann beispielsweise der Gleichstrom sein, der sich ab dem Zeitpunkt t1 einstellt.

**Fig. 7** zeigt ein Ablaufdiagramm eines Ausführungsbeispiels eines Verfahrens zum Betreiben einer optoelektronischen Baugruppe, beispielsweise der im Vorhergehenden erläuterten optoelektronischen Baugruppe 10. Das Verfahren dient dazu, zu erkennen, ob ein Aufheizen des organischen lichtemittierenden Bauelements 1 nötig ist, das Aufheizen durchzuführen, wenn es nötig ist, das Aufheizen zu beenden, wenn es nicht mehr nötig ist, und dann in den normalen Betrieb umzuschalten. Das Verfahren wird bei einem Anschalten des organischen lichtemittierenden Bauelements 1 abgearbeitet, insbesondere von dem Steuergerät 50.

In einem Schritt S2 wird der Temperaturwert erfasst, beispielsweise mit Hilfe des im Vorhergehenden erläuterten ersten Sensors 52.

In einem Schritt S4 wird überprüft, ob der erfasste Temperaturwert kleiner als ein vorgegebener Temperaturschwellenwert ist. Ist die Bedingung in dem Schritt S4 erfüllt, so wird die Bearbeitung in einem Schritt S6 fortgesetzt. Ist die Bedingung in dem Schritt S4 nicht erfüllt, so wird die Bearbeitung in einem Schritt S12 fortgesetzt.

In dem Schritt S6 wird eine Wechselspannung Uw an das organische lichtemittierende Bauelement 1 angelegt. Die Wechselspannung Uw ist zumindest zeitweise kleiner als die aktuelle Schwellenspannung Uth des organischen lichtemittierenden Bauelements 1.

In einem Schritt S8 wird ein Messwert erfasst. Insbesondere kann erneut ein Temperaturwert erfasst werden. Alternativ dazu kann ein Stromwert eines Vorwärtsstroms, der über die organische funktionelle Schichtenstruktur 22 fließt, erfasst werden oder es kann ein Zeitwert einer Zeitdauer erfasst werden, die seit dem Anschalten des organischen lichtemittierenden Bauelements 1 vergangen ist. Falls als Messwert der Stromwert erfasst wird, so kann als Messwert beispielsweise ein Maximum der Wechselstromamplitude erfasst bzw. gemessen werden.

In einem Schritt S10 wird überprüft, ob der erfasste Messwert kleiner als ein vorgegebener Schwellenwert ist. Im Falle des Temperaturwerts kann überprüft werden, ob der erfasste Temperaturwert kleiner als der vorgegebene Temperaturschwellenwert ist. Der in dem Schritt S10 vorgegebene Temperaturschwellenwert kann der gleiche oder ein anderer Temperaturschwellenwert wie der in dem Schritt S4 vorgegebene Temperaturschwellenwert sein.

Alternativ dazu kann in dem Schritt S10 überprüft werden, ob der Stromwert kleiner als ein vorgegebener Stromschwellenwert oder der Zeitwert kleiner als ein vorgegebener Zeitschwellenwert ist. Der vorgegebene Stromschwellenwert und/oder der vorgegebene Zeitschwellenwert können beispielsweise werkseitig ermittelt und so vorgegeben werden, dass bei deren Überschreiten die organische funktionelle Schichtenstruktur 22 sicher eine für den normalen Betrieb ausreichende Temperatur hat. Der vorgegebene Stromschwellenwert kann in einem Bereich liegen beispielsweise von 20%bis 100% des OLED Nennbetriebsstroms, beispielsweise von 40% bis 90% des Nennbetriebsstroms, beispielsweise von 60% bis 80% des Nennbetriebsstroms. Der vorgegebene Zeitschwellenwert kann in einem Bereich liegen beispielsweise von 0,2 s bis 30 s, beispielsweise von 0,5 s bis 10 s, beispielsweise von 1 bis 5 s. Ist die Bedingung in dem Schritt S10 erfüllt, so wird die Bearbeitung erneut in dem Schritt S8 fortgesetzt. Ist die Bedingung des Schritt S10 nicht erfüllt, so wird die Bearbeitung in dem Schritt S 12 fortgesetzt.

In dem Schritt S12 wird eine Gleichspannung Ug an das organische lichtemittierende Bauelement 1 angelegt, wobei die Gleichspannung Ug größer als die aktuelle Schwellenspannung Uth ist. In anderen Worten wird in dem Schritt S12 in den normalen Betrieb übergegangen, wohingegen die Schritte S2 bis S10 den Aufheizvorgang nach dem Anschalten und vor dem normalen Betrieb des organischen lichtemittierenden Bauelements 1 darstellen.

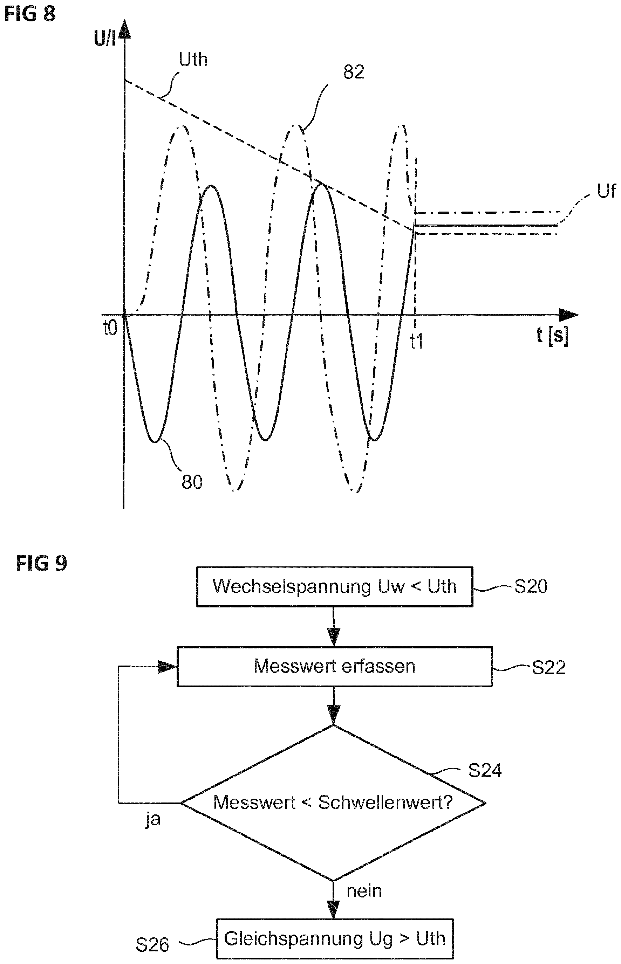

**Fig. 8** und **Fig. 9** dienen gemeinsam zum Erläutern eines Ausführungsbeispiels eines Verfahrens zum Betreiben einer optoelektronischen Baugruppe, beispielsweise der im Vorhergehenden erläuterten optoelektronischen Baugruppe 10.

Figur 8 zeigt ein Zeit-Spannung-Diagramm, in dem ein zweiter Spannungsverlauf 80 einer Wechselspannung, die in der Aufwärmphase an das organische lichtemittierende Bauelement 1 angelegt wird, und eine Vorwärtsspannung Uf, die im normalen Betrieb an das organische lichtemittierende Bauelement 1 angelegt wird, als durchgezogene Linie dargestellt sind. Des Weiteren ist eine aktuelle Schwellenspannung Uth als gestrichelte Linie dargestellt Die aktuelle Schwellenspannung Uth nimmt während der Aufwärmphase aufgrund der zunehmenden Eigentemperatur des organischen lichtemittierenden Bauelements 1 ab.

Neben den erwähnten Spannungen ist in dem in Figur 8 gezeigten Diagramm als Strich-Punkt-Linie ein zweiter Stromverlauf 82 des Stroms dargestellt, mit dem das organische lichtemittierende Bauelement 1 betrieben wird.

Die dargestellte Schwingung der Wechselspannung beginnt zu einem Zeitpunkt t0, an dem das organische lichtemittierende Bauelement 1 eingeschaltet wurde. Die Wechselspannung dient zum Aufheizen des organischen lichtemittierenden Bauelements 1 und wird obligatorisch bei jedem Anschalten des organischen lichtemittierenden Bauelements 1 zumindest kurzzeitig angelegt. Die Wechselspannung wird bis zu einem Zeitpunkt t1 angelegt, an dem erkannt wird, dass ein weiteres Aufheizen des organischen lichtemittierenden Bauelements 1 nicht mehr nötig ist. Zum Zeitpunkt t1 wird eine Gleichspannung, insbesondere die Vorwärtsspannung Uf an das organische lichtemittierende Bauelement 1 angelegt. Die Gleichspannung ist kleiner als die aktuelle Schwellenspannung zum Zeitpunkt t0 und größer als die aktuelle Schwellenspannung Uth zum Zeitpunkt t1.

Der zweite Stromverlauf 82 folgt dem zweiten Spannungsverlauf 80 in den Zeitabschnitten, in denen die Wechselspannung kleiner als die aktuelle Schwellenspannung Uth ist und in denen kein Strom über die organische funktionelle Schichtenstruktur 22 fließt und kein Licht emittiert wird, mit einer Phasenverschiebung von 90°. Nach Anlegen der Gleichspannung zum Zeitpunkt t1 und Beginn des normalen Betriebs fließt Gleichstrom über das organische lichtemittierende Bauelement 1 und das organische lichtemittierende Bauelement 1 emittiert Licht. Die maximale Amplitude des zweiten Stromverlaufs 82 vor dem Zeitpunkt t1, also während der Aufwärmphase, ist größer als der konstante Wert des ersten Stromverlaufs nach dem Zeitpunkt t1, also im Normal- oder Nennbetrieb. Dies kann dazu beitragen, dass der Effektivstromwert während der Aufwärmphase besonders hoch ist, wodurch eine besonders schnelle Aufwärmung erfolgt.

Der zweite Spannungsverlauf 80 ist sinusförmig. Alternativ dazu kann der zweite Spannungsverlauf 80 sägezahnförmig oder trapezförmig und/oder bipolar oder unipolar sein. Die Wechselspannung ist hochfrequent, beispielsweise im Kilohertz- bis Megahertz-Bereich. Die Wechselspannung kann abhängig von der Kapazität des Kondensator 42, des Elektrodenwiderstands 46 und/oder der Schwellenspannung Uth des organischen lichtemittierenden Bauelements 1 ausgelegt werden. Die maximale Amplitude des zweiten Spannungsverlaufs 80 ist immer kleiner als die aktuelle Schwellenspannung Uth. Dies ist besonders günstig bei OLEDs mit hoher Schwellenspannung Uth, beispielsweise bei OLEDs mit mehrfach gestapelten organischen funktionellen Schichtenstrukturen 22, da diese bei besonders kleiner Frequenz mit einem besonders hohen Strom aufgeheizt werden können.

Die Heizleistung kann beispielsweise so gewählt werden, dass das lichtemittierende Bauelement 1 besonders schnell jedoch nicht unnötig hoch erwärmt wird. Beispielsweise kann eine maximale gewünschte Temperaturänderung so gewählt werden, dass sie der Temperaturänderung im normalen Betrieb des organischen lichtemittierenden Bauelements 1 entspricht, die sich nach ausreichend langer Zeit stationär einstellt. Diese Temperaturänderung kann beispielsweise werkseitig empirisch ermittelt werden. Die Heizenergie kann über die Frequenz, die Spannungsamplitude und die Zeitdauer des Heizens eingestellt werden. Bevorzugt werden Spannung und Frequenz so gewählt, dass die Stromamplitude und/oder der Effektivstromwert des Wechselstroms größer sind als der Stromwert des Gleichstroms im Normal- oder Nennbetrieb. Beispielsweise kann der Effektivwert des Wechselstroms im Bereich des ein- bis zwanzigfachen Nennstroms, beispielsweise im Bereich des dreibis fünfzehnfachen Nennstroms oder im Bereich des fünf- bis zehnfachen Nennstroms liegen. Der Nennbetriebsstrom kann beispielsweise der Gleichstrom sein, der sich ab dem Zeitpunkt t1 einstellt.

**Fig. 9** zeigt ein Ablaufdiagramm eines Ausführungsbeispiels eines Verfahrens zum Betreiben einer optoelektronischen Baugruppe, beispielsweise der im Vorhergehenden erläuterten optoelektronischen Baugruppe 10. Das Verfahren wird jedes Mal beim Einschalten des organischen lichtemittierenden Bauelements 1 abgearbeitet. Das Verfahren dient dazu, ein Aufheizen des organischen lichtemittierenden Bauelements 1 durchzuführen, das Aufheizen zu beenden, wenn es nicht mehr nötig ist, und dann in den normalen Betrieb umzuschalten. Das Verfahren wird insbesondere von dem Steuergerät 50 abgearbeitet.

In einem Schritt S20 wird eine Wechselspannung Uw an das organische lichtemittierende Bauelement 1 angelegt, wobei die Wechselspannung Uw zu jedem Zeitpunkt kleiner als eine aktuelle Schwellenspannung Uth des organischen lichtemittierenden Bauelements 1 ist.

In einem Schritt S22 wird ein Messwert erfasst. Beispielsweise wird der Temperaturwert erfasst. Alternativ dazu kann der Stromwert oder der Zeitwert erfasst werden.

In einem Schritt S24 wird geprüft, ob der erfasste Messwert kleiner als ein vorgegebener Schwellenwert ist. Beispielsweise wird geprüft, ob der Temperaturwert kleiner als der vorgegebene Temperaturschwellenwert, der Stromwert kleiner als der vorgegebene Stromschwellenwert oder der Zeitwert kleiner als der vorgegebene Zeitschwellenwert ist. Ist die Bedingung in dem Schritt S24 erfüllt, so wird die Bearbeitung erneut in dem Schritt S22 fortgesetzt. Ist die Bedingung in dem Schritt S24 nicht erfüllt, so wird die Bearbeitung in einem Schritt S26 fortgesetzt.

In dem Schritt S26 wird eine Gleichspannung Ug an das organische lichtemittierende Bauelement 1 angelegt, wobei die Gleichspannung Ug größer als die aktuelle Schwellenspannung Uth zum Zeitpunkt t1 ist. In anderen Worten wird in dem Schritt S26 der normale Betrieb, insbesondere der Leuchtbetrieb, des organischen lichtemittierenden Bauelements 1 aufgenommen.

Die Erfindung ist nicht auf die angegebenen Ausführungsbeispiele beschränkt. Beispielsweise kann bei allen Ausführungsbeispielen die Schwellenspannung Uth variieren. Ferner können die Spannungsverläufe bezüglich ihrer Phase, Amplitude und/oder Form anders als die dargestellten Spannungsverläufe gewählt sein. Ferner kann das organische lichtemittierende Bauelement 1 im Detail von dem dargestellten organischen lichtemittierenden Bauelement 1 Abweichen, beispielsweise kann auf den Abdeckkörper und/oder das Substrat verzichtet werden und/oder es kann weitere elektronische, optische und/oder optoelektronische Elemente aufweisen. Ferner kann die dargestellte optoelektronische Baugruppe 10 weitere elektronische Bauelemente, beispielsweise ein Speichermedium, oder weitere organische lichtemittierende Bauelemente 1 aufweisen.

**BEZUGSZEICHENLISTE**

| | |
|---|---|
| Organisches lichtemittierendes Bauelement | 1 |
| Träger | 12 |
| Erste Elektrodenschicht | 14 |
| Erster Kontaktabschnitt | 16 |
| Zweiter Kontaktabschnitt | 18 |
| Erste Elektrode | 20 |
| Isolierungsbarriere | 21 |
| Organische funktionelle Schichtenstruktur | 22 |
| Zweite Elektrode | 23 |
| Verkapselungsschicht | 24 |
| Erster Kontaktbereich | 32 |
| Zweiter Kontaktbereich | 34 |
| Haftmittelschicht | 36 |
| Abdeckkörper | 38 |
| Diode | 40 |
| Kondensator | 42 |
| Bulkwiderstand | 44 |
| Elektrodenwiderstand | 46 |
| Spannungsquelle | 48 |
| Steuergerät | 50 |
| Erster Sensor | 52 |
| Zweiter Sensor | 54 |
| Vorwärtsspannung | Uf |
| Wechselspannung | Uw |
| Schwellenspannung | Uth |
| Gleichspannung | Ug |
| Schritte | S2 bis S26 |

## Patentansprüche

1. Optoelektronische Baugruppe (10) aufweisend
ein organisches lichtemittierendes Bauelement (1), wobei eine Schwellenspannung des organischen lichtemittierenden Bauelements Temperatur abhängig ist,
einen Temperatursensor (52) zum Erfassen von Temperaturwerten jeweils repräsentativ für eine Temperatur des organischen lichtemittierenden Bauelements und
ein Steuergerät (50), das mit dem organischen lichtemittierenden Bauelement (1) und dem Temperatursensor (52) gekoppelt ist und das dazu eingerichtet ist, das organische lichtemittierende Bauelement (1) anzuschalten, und zu überprüfen ob der von dem Temperatursensor beim Anschalten erfasste Temperaturwert kleiner als ein vorgegebener Temperaturschwellenwert ist,
und falls der erfasste Temperaturwert kleiner als der vorgegebene Temperaturschwellenwert ist an das organische lichtemittierende Bauelement (1) eine Wechselspannung (Uw) anzulegen, die zumindest zeitweise kleiner als die jeweilige aktuelle Schwellenspannung (Uth) des organischen lichtemittierenden Bauelements (1) ist und zu überprüfen ob ein erneut erfasster Temperaturwert kleiner als der vorgegebener Temperaturschwellenwert ist,
und falls der beim Anschalten oder der erneut erfasste Temperaturwert gleich wie oder grösser als der vorgegebene Temperaturschwellenwert ist,
an das organische lichtemittierende Bauelement (1) eine Gleichspannung (Ug) anzulegen, die größer als die jeweilige aktuelle Schwellenspannung (Uth) des organischen lichtemittierenden Bauelements (1) ist.

2. Optoelektronische Baugruppe (10) nach Anspruch 1, bei der das Steuergerät (50) so eingerichtet ist, dass die Wechselspannung (Uw) immer kleiner als die jeweilige aktuelle Schwellenspannung (Uth) des organischen lichtemittierenden Bauelements (1) ist.

3. Optoelektronische Baugruppe (10), aufweisend
ein organisches lichtemittierendes Bauelement (1),
eine Messvorrichtung zum Erfassen eines Messwerts und
ein Steuergerät (50), das mit dem organischen lichtemittierenden Bauelement (1) und der Messvorrichtung (52) gekoppelt ist und das dazu eingerichtet ist, das organische lichtemittierende Bauelement (1) einzuschalten, bei dem Einschalten des organischen lichtemittierenden Bauelementes (1) an das organische lichtemittierende Bauelement (1) eine Wechselspannung (Uw) anzulegen, die zumindest zeitweise kleiner als eine erste aktuelle Schwellenspannung (Uth) des organischen lichtemittierenden Bauelements (1) ist,
und zu überprüfen ob der nach dem Anlegen der Wechselspannung erfasste Messwert kleiner als ein vorgegebener Schwellenwert ist und falls der erfasste Messwert kleiner als der vorgegebene Schwellenwert ist einen erneut erfassten Messwert zu überprüfen,
und an das organische lichtemittierende Bauelement (1) eine Gleichspannung (Ug) anzulegen, die größer als eine zweite aktuelle Schwellenspannung (Uth) des organischen lichtemittierenden Bauelements (1) ist, falls der erfasste Messwert oder der erneut erfasste Messwert gleich wie oder grösser als der vorgegebene Schwellenwert ist,
wobei die Messvorrichtung einen Temperatursensor als Messvorrichtung zum Erfassen eines Temperaturwerts repräsentativ für eine Temperatur des organischen lichtemittierende Bauelements aufweist, wobei der Messwert der Temperaturwert ist und der Schwellwert ein vorgegebener Temperaturschwellenwert ist,
oder die Messvorrichtung einen Stromsensor als Messvorrichtung zum Erfassen eines Stromwerts eines Vorwärtsstroms, der über das organische lichtemittierende Bauelement (1) fließt, aufweist, wobei der Messwert der Stromwert ist und der Schwellenwert ein vorgegebener Stromschwellenwert ist, oder wobei die Messvorrichtung eine Uhr als Messvorrichtung zum Erfassen einer Zeitdauer, die seit dem Anschalten des organischen lichtemittierenden Bauelements (1) vergangen ist, aufweist, wobei der Messwert der Zeitdauer entspricht und der Schwellenwert ein vorgegebener Zeitschwellenwert ist.

4. Verfahren zum Betreiben einer optoelektronischen Baugruppe (10) aufweisend
ein organisches lichtemittierendes Bauelement (1), wobei eine Schwellenspannung des organischen lichtemittierenden Bauelements Temperatur abhängig ist, einen Temperatursensor (52) zum Erfassen von Temperaturwerten und eine Steuergerät (50), das mit dem organischen lichtemittierenden Bauelement (1) und dem Temperatursensor (52) gekoppelt ist,
aufweisend die Schritte
- Anschalten des organischen lichtemittierenden Bauelements mittels des Steuergeräts,
- Erfassen eines Temperaturwerts des organischen lichtemittierenden Bauelements (1) welcher repräsentativ für eine Temperatur des organischen lichtemittierenden Bauelements mittels des Temperatursensors (52), und
- Überprüfen, mittels des Steuergeräts, ob der erfasste Temperaturwert kleiner als ein vorgegebener Temperaturschwellenwert ist, und falls der erfasste Temperaturwert kleiner als der vorgegebene Temperaturschwellenwert ist, Anlegen einer Wechselspannung (Uw) an das organische lichtemittierende Bauelement (1) mittels des Steuergeräts, wobei die Wechselspannung zumindest zeitweise kleiner als die jeweilige aktuelle Schwellenspannung (Uth) des organischen lichtemittierenden Bauelements (1) ist und
- Überprüfen, mittels des Steuergeräts, ob ein erneut erfasster Temperaturwert kleiner als der vorgegebene Temperaturschwellenwert ist, und, falls der bei dem Anschalten oder der erneut erfasste Temperaturwert gleich wie oder größer als der vorgegebene Temperaturschwellenwert ist, Anlegen einer Gleichspannung (Ug), die größer als die jeweilige aktuelle Schwellenspannung (Uth) des organischen lichtemittierenden Bauelements (1) ist.

5. Verfahren nach Anspruch 4, bei dem die Wechselspannung (Uw) immer kleiner als die jeweilige aktuelle Schwellenspannung (Uth) des organischen lichtemittierenden Bauelements (1) ist.

6. Verfahren zum Betreiben einer optoelektronischen Baugruppe (10) aufweisend
ein organisches lichtemittierendes Bauelement (1), eine Messvorrichtung zum Erfassen eines Messwertes und ein Steuergerät (50), das mit dem organischen lichtemittierenden Bauelement (1) und der Messvorrichtung (52) gekoppelt ist,
aufweisend die Schritte
- Anschalten des organischen lichtemittierenden Bauelements und Anlegen einer Wechselspannung an das organische lichtemittierende Bauelement (1) mittels des Steuergeräts, wobei die angelegte Wechselspannung (Uw) kleiner als eine erste aktuelle Schwellenspannung (Uth) des organischen lichtemittierenden Bauelements (1) ist,
- Erfassen eines Messwerts mittels der Messvorrichtung,
- Überprüfen, mittels des Steuergeräts, ob der erfasste Messwert kleiner als ein vorgegebener Schwellenwert ist und falls der erfasste Messwert kleiner als der vorgegebene Schwellenwert ist, erneutes Überprüfen eines weiteren erfassten Messwerts mittels des Steuergeräts, und falls der erfasste Messwert oder der weitere Messwert gleich wie oder größer als der vorgegebene Schwellenwert ist, Anlegen einer Gleichspannung an das organische lichtemittierende Bauelement (1) mittels des Steuergeräts, wobei die angelegte Gleichspannung (Ug) größer als eine zweite aktuelle Schwellenspannung (Uth) des organischen lichtemittierenden Bauelements (1) ist,
wobei der Messwert ein Temperaturwert repräsentativ für eine Temperatur des organischen lichtemittierende Bauelements ist und der Schwellenwert ein vorgegebener Temperaturschwellenwert ist, oder wobei der Messwert ein Stromwert eines Vorwärtsstroms ist, der über das organische lichtemittierende Bauelement (1) fließt, und bei dem der Schwellenwert ein vorgegebener Stromschwellenwert ist, oder wobei der Messwert einer Zeitdauer entspricht, die seit dem Anschalten des organischen lichtemittierenden Bauelements (1) vergangen ist, und bei dem der Schwellenwert ein vorgegebener Zeitschwellenwert ist.

7. Verfahren nach einem der Ansprüche 4 bis 6, bei dem die Wechselspannung (Uw) so gewählt wird, dass ein Effektivstromwert des dadurch verursachten Wechselstroms größer ist als der Stromwert des Gleichstroms, der durch die Gleichspannung (Ug) verursacht wird.

## Claims

1. Optoelectronic assembly (10) comprising
an organic light emitting component (1), wherein a threshold voltage of the organic light emitting component is temperature dependent,
a temperature sensor (52) for recording temperature values each representative for a temperature of the organic light emitting component, and
a controller (50) coupled with the organic light emitting component (1) and the temperature sensor (52) and configured to switch on the organic light emitting component (1) and to check whether the temperature value recorded by the temperature sensor at switch-on is smaller than a predetermined temperature threshold,
and, if the recorded temperature value is smaller than the predetermined temperature threshold value, to apply an alternating current voltage (Uw) to the organic light-emitting component (1) which is at least temporarily smaller than the respective instantaneous threshold voltage (Uth) of the organic light-emitting component (1) and to check whether an again recorded temperature value is smaller than the predetermined temperature threshold value,
and, if the temperature value recorded at switch-on or the again recorded temperature value is equal to or greater than the predetermined temperature threshold,
to apply to the organic light-emitting component (1) a direct current voltage (Ug) which is greater than the respective instantaneous threshold voltage (Uth) of the organic light-emitting component (1).

2. Optoelectronic assembly (10) according to claim 1, wherein the controller (50) is configured such that the alternating current voltage (Uw) is always smaller than the respective threshold voltage (Uth) of the organic light-emitting component (1).

3. Optoelectronic assembly (10), comprising
an organic light emitting component (1),
a measuring device for recording a measurement value, and
a controller (50) coupled with the organic light emitting component (1) and the measuring device (52) and configured to switch on the organic light emitting component (1),
on switching-on the organic light-emitting component (1), to apply to the organic light-emitting component (1) an alternating current voltage (Uw) which is at least temporarily smaller than a first instantaneous threshold voltage (Uth) of the organic light-emitting component (1), and to check whether the recorded measurement value after applying the alternating current voltage is smaller than a predetermined threshold value and, if the recorded measurement value is smaller than the predetermined threshold value, to check an again recorded measurement value,
and to apply to the organic light emitting component (1) a direct current voltage (Ug) which is greater than a second instantaneous threshold voltage (Uth) of the organic light emitting component (1) if the recorded measurement value or the again recorded measurement value is equal to or greater than the predetermined threshold value,
wherein the measuring device comprises a temperature sensor as a measuring device for recording a temperature value representative of a temperature of the organic light emitting component, wherein the measurement value is the temperature value and the threshold value is a predetermined temperature threshold value,
or the measuring device comprises a current sensor as measuring device for recording a current value of a forward current flowing across said organic light emitting component (1), wherein the measurement value is the current value and the threshold value is a predetermined current threshold value, or the measuring device comprises a clock as measuring device for recording a time duration elapsed since the organic light emitting component (1) is switched on, wherein the measurement value corresponds to the time duration and the threshold value is a predetermined time threshold value.

4. Method for operating an optoelectronic assembly (10) comprising
an organic light emitting component (1), wherein a threshold voltage of the organic light emitting component is temperature dependent, a temperature sensor (52) for recording temperature values, and a controller (50) connected with the organic light emitting component (1) and the temperature sensor (52),
comprising the steps of
- Switching on the organic light emitting component by means of the controller,
- recording a temperature value of the organic light emitting component (1) which is representative of a temperature of the organic light emitting component by means of the temperature sensor (52), and
- checking, by means of the controller, whether the recorded temperature value is smaller than a predetermined temperature threshold value, and if the recorded temperature value is smaller than the predetermined temperature threshold value, applying an alternating current voltage (Uw) to the organic light-emitting component (1) by means of the controller, the alternating current voltage being at least temporarily smaller than the respective instantaneous threshold voltage (Uth) of the organic light-emitting component (1), and
- checking, by means of the controller, whether an again recorded temperature value is smaller than the predetermined temperature threshold value, and, if the temperature value recorded at the time of switching on or the again recorded temperature value is equal to or greater than the predetermined temperature threshold value, applying a direct current voltage (Ug) which is greater than the respective instantaneous threshold voltage (Uth) of the organic light-emitting component (1) .

5. Method according to claim 4, in which the alternating current voltage (Uw) is always smaller than the respective instantaneous threshold voltage (Uth) of the organic light-emitting component (1).

6. Method for operating an optoelectronic assembly (10) comprising
an organic light-emitting component (1), a measuring device for recording a measurement value, and a controller (50) coupled with the organic light-emitting component (1) and the measuring device (52), comprising the steps of
- switching on the organic light emitting component and applying an alternating current voltage to the organic light emitting component (1) by means of the controller, wherein the applied alternating current voltage (Uw) is smaller than a first instantaneous threshold voltage (Uth) of the organic light emitting component (1),
- recording a measurement value by means of the measuring device,
- checking, by means of the controller, whether the recorded measurement value is smaller than a predetermined threshold value, and if the recorded measurement value is smaller than the predetermined threshold value, checking again a further recorded measurement value by means of the controller, and if the recorded measurement value or the further measurement value is equal to or greater than the predetermined threshold value, applying a direct current voltage to the organic light-emitting component (1) by means of the controller, the applied direct current voltage (Ug) being greater than a second instantaneous threshold voltage (Uth) of the organic light-emitting component (1),
wherein the measurement value is a temperature value representative of a temperature of the organic light emitting component and the threshold value is a predetermined temperature threshold value, or wherein the measurement value is a current value of a forward current flowing across the organic light emitting component (1), and wherein the threshold value is a predetermined current threshold value, or wherein the measurement value corresponds to a time duration that has elapsed since the organic light emitting component (1) was switched on, and wherein the threshold value is a predetermined time threshold value.

7. Method according to any of claims 4 to 6, wherein the alternating current voltage (Uw) is selected such that an RMS current value of the alternating current caused thereby is greater than the current value of the direct current caused by the direct current voltage (Ug).

## Revendications

1. Module optoélectronique (10) comprenant
un composant organique émetteur de lumière (1), dans lequel une tension de seuil du composant organique émetteur de lumière dépend de la température,
un capteur de température (52) pour détecter des valeurs de température représentatives chacune d'une température du composant organique émetteur de lumière, et
un appareil de commande (50) qui est couplé au composant organique émetteur de lumière (1) et au capteur de température (52) et qui est conçu pour mettre en marche le composant organique émetteur de lumière (1) et pour vérifier si la valeur de température détectée par le capteur de température lors de la mise en marche est inférieure à une valeur seuil de température prédéfinie,
et si la valeur de température détectée est inférieure à la valeur de seuil de température prédéfinie, appliquer au composant organique émetteur de lumière (1) une tension alternative (Uw) qui est au moins temporairement inférieure à la tension de seuil actuelle (Uth) respective du composant organique émetteur de lumière (1) et vérifier si une valeur de température détectée à nouveau est inférieure à la valeur de seuil de température prédéfinie,
et si la valeur de température détectée lors de la mise en marche ou la valeur de température détectée à nouveau est égale ou supérieure à la valeur seuil de température prédéfinie,
appliquer au composant organique émetteur de lumière (1) une tension continue (Ug) qui est supérieure à la tension de seuil actuelle (Uth) respective du composant organique émetteur de lumière (1).

2. Module optoélectronique (10) selon la revendication 1, dans lequel l'appareil de commande (50) est conçu de telle sorte que la tension alternative (Uw) est toujours inférieure à la tension de seuil (Uth) respective du composant organique émetteur de lumière (1).

3. Module optoélectronique (10), comprenant
un composant organique émetteur de lumière (1),
un dispositif de mesure pour détecter une valeur de mesure et un appareil de commande (50) qui est couplé au composant organique émetteur de lumière (1) et au dispositif de mesure (52) et qui est conçu pour mettre en marche le composant organique émetteur de lumière (1),
lors de la mise en marche du composant organique émetteur de lumière (1), appliquer au composant organique émetteur de lumière (1) une tension alternative (Uw) qui est au moins temporairement inférieure à une première tension de seuil actuelle (Uth) du composant organique émetteur de lumière (1),
et vérifier si la valeur de mesure détectée après l'application de la tension alternative est inférieure à une valeur de seuil prédéterminée et, si la valeur de mesure détectée est inférieure à la valeur de seuil prédéterminée, vérifier une valeur de mesure détectée à nouveau,
et appliquer au composant organique émetteur de lumière (1) une tension continue (Ug) qui est supérieure à une deuxième tension de seuil actuelle (Uth) du composant organique émetteur de lumière (1) si la valeur de mesure détectée ou la valeur de mesure détectée à nouveau est égale ou supérieure à la valeur de seuil prédéterminée,
dans lequel le dispositif de mesure comprend un capteur de température en tant que dispositif de mesure pour détecter une valeur de température représentative d'une température du composant organique émetteur de lumière, dans lequel la valeur de mesure est la valeur de température et la valeur de seuil est une valeur de seuil de température prédéterminée,
ou le dispositif de mesure comprend un capteur de courant en tant que dispositif de mesure pour détecter une valeur de courant d'un courant direct circulant à travers le composant organique émetteur de lumière (1), dans lequel la valeur de mesure est la valeur de courant et la valeur de seuil est une valeur de seuil de courant prédéterminée, ou dans lequel le dispositif de mesure comprend une horloge en tant que dispositif de mesure pour détecter une durée qui s'est écoulée depuis la mise en marche du composant organique émetteur de lumière (1), dans lequel la valeur de mesure correspond à la durée et la valeur de seuil est une valeur de seuil de temps prédéterminée.

4. Procédé d'exploitation d'un module optoélectronique (10) comprenant
un composant organique émetteur de lumière (1), dans lequel une tension de seuil du composant organique émetteur de lumière dépend de la température, un capteur de température (52) pour détecter des valeurs de température et un appareil de commande (50) qui est couplé au composant organique émetteur de lumière (1) et au capteur de température (52),
comprenant les étapes suivantes
- mettre en marche le composant organique émetteur de lumière au moyen de l'appareil de commande,
- détecter une valeur de température du composant organique émetteur de lumière (1) qui est représentative d'une température du composant organique émetteur de lumière au moyen du capteur de température (52), et
- vérifier, au moyen de l'appareil de commande, si la valeur de température détectée est inférieure à une valeur de seuil de température prédéfinie, et si la valeur de température détectée est inférieure à la valeur de seuil de température prédéfinie, appliquer une tension alternative (Uw) au composant organique émetteur de lumière (1) au moyen de l'appareil de commande, dans lequel la tension alternative est au moins temporairement inférieure à la tension de seuil actuelle (Uth) respective du composant organique émetteur de lumière (1) et
- vérifier, au moyen de l'appareil de commande, si une valeur de température détectée à nouveau est inférieure à la valeur de seuil de température prédéterminée et, si la valeur de température détectée lors de la mise en marche ou la valeur de température détectée à nouveau est égale ou supérieure à la valeur de seuil de température prédéterminée, appliquer une tension continue (Ug) qui est supérieure à la tension de seuil actuelle (Uth) respective du composant organique émetteur de lumière (1).

5. Procédé selon la revendication 4, dans lequel la tension alternative (Uw) est toujours inférieure à la tension de seuil actuelle (Uth) respective du composant organique émetteur de lumière (1).

6. Procédé d'exploitation d'un module optoélectronique (10) comprenant
un composant organique émetteur de lumière (1), un dispositif de mesure pour détecter une valeur de mesure et un appareil de commande (50) qui est couplé au composant organique émetteur de lumière (1) et au dispositif de mesure (52),
comprenant les étapes suivantes
- mettre en marche le composant organique émetteur de lumière et appliquer une tension alternative au composant organique émetteur de lumière (1) au moyen de l'appareil de commande, dans lequel la tension alternative appliquée (Uw) est inférieure à une première tension de seuil actuelle (Uth) du composant organique émetteur de lumière (1),
- détecter une valeur de mesure au moyen du dispositif de mesure,
- vérifier, au moyen de l'appareil de commande, si la valeur de mesure détectée est inférieure à une valeur seuil prédéterminée et, si la valeur de mesure détectée est inférieure à la valeur seuil prédéterminée, vérifier à nouveau une autre valeur de mesure détectée au moyen de l'appareil de commande, et si la valeur de mesure détectée ou l'autre valeur de mesure est égale ou supérieure à la valeur de seuil prédéterminée, appliquer une tension continue au composant organique émetteur de lumière (1) au moyen de l'appareil de commande, dans lequel la tension continue appliquée (Ug) est supérieure à une deuxième tension de seuil actuelle (Uth) du composant organique émetteur de lumière (1),
dans lequel la valeur de mesure est une valeur de température représentative d'une température du composant organique émetteur de lumière et la valeur de seuil est une valeur de seuil de température prédéterminée, ou dans lequel la valeur de mesure est une valeur de courant d'un courant direct circulant à travers le composant organique émetteur de lumière (1), et dans lequel la valeur de seuil est une valeur de seuil de courant prédéterminée, ou dans lequel la valeur de mesure correspond à une durée écoulée depuis la mise en marche du composant organique émetteur de lumière (1), et dans lequel la valeur de seuil est une valeur de seuil de temps prédéterminée.

7. Procédé selon l'une quelconque des revendications 4 à 6, dans lequel la tension alternative (Uw) est choisie de telle sorte qu'une valeur de courant efficace du courant alternatif ainsi provoqué soit supérieure à la valeur de courant du courant continu provoqué par la tension continue (Ug).
